# DEMANDE DE BREVET EUROPEEN

(11) **EP 3 913 812 A1**
(43) Date de publication de la demande: **24.11.2021**
(21) Numéro de dépôt: 21173191.4
(22) Date de dépôt: 11.05.2021
(51) Int. Cl.: H04B 1/04, H04B 1/18, H03H 7/40, H04B 1/525

(54) **ADAPTATION D'IMPÉDANCE**

(30) Priorité: 19.05.2020 FR 2005058
(71) Demandeur: STMicroelectronics (Tours) SAS, 37100 Tours (FR)
(72) Inventeur: PROOT, Jean Pierre, 37540 SAINT CYR SUR LOIRE (FR); PAILLET, Pascal, 37540 SAINT CYR SUR LOIRE (FR); DUPONT, François, 37000 TOURS (FR)
(74) Mandataire: Cabinet Beaumont

(57) **Abrégé**

La présente description concerne un dispositif comprenant : une antenne (2) ; un coupleur directionnel (4) comprenant un premier port (401) recevant un signal radiofréquence, un deuxième port (402) vers lequel est transmis un signal reçu par le premier port (401) et un troisième port (403) vers lequel est transmis un signal reçu par le deuxième port (402) ; un réseau d'adaptation d'impédance (3') connecté entre le deuxième port (402) et l'antenne (2) et comprenant des composants inductifs et/ou capacitifs (C1', L1, C2', L2, C3) dont un unique composant inductif ou capacitif (C3) à valeur réglable ; et une diode (6) reliant le troisième port (403) du coupleur (4) à une borne de mesure (104) du dispositif (1') configurée pour être connectée à un convertisseur analogique numérique.

## Description

### Domaine technique

La présente description concerne de façon générale les circuits électroniques, et plus particulièrement les circuits comprenant une antenne pour émettre des signaux radiofréquences.

### Technique antérieure

Il est connu d'adapter l'impédance d'une antenne radiofréquence destinée à émettre un signal radiofréquence à celle d'une source radiofréquence fournissant le signal radiofréquence à émettre. En particulier, des dispositifs connus permettent d'adapter l'impédance d'une antenne à celle d'une source radiofréquence lorsque l'antenne est placée dans son environnement d'utilisation et que cet environnement provoque un décalage ("mismatch" en anglais) d'impédance entre la source radiofréquence et l'antenne.

Toutefois, ces dispositifs connus souffrent de divers inconvénients.

### Résumé de l'invention

Il existe un besoin de pallier tout ou partie des inconvénients des dispositifs connus d'adaptation d'impédance mentionnés précédemment.

Un mode de réalisation pallie tout ou partie des inconvénients des dispositifs connus d'adaptation d'impédance mentionnés précédemment.

Un mode de réalisation prévoit un dispositif comprenant :
une antenne ;
un coupleur directionnel comprenant un premier port configuré pour être connecté à une source d'un signal radiofréquence, un deuxième port vers lequel est transmis un signal reçu par le premier port et un troisième port vers lequel est transmis un signal reçu par le deuxième port ;
un réseau d'adaptation d'impédance comprenant des composants inductifs et/ou capacitifs à valeur fixe et un unique composant inductif ou capacitif à valeur réglable, une borne d'entrée du réseau étant reliée au deuxième port du coupleur et une borne de sortie du réseau étant reliée à l'antenne ; et
une diode reliant le troisième port du coupleur à une borne de mesure du dispositif configurée pour être connectée à un convertisseur analogique numérique.

Selon un mode de réalisation, le réseau d'adaptation d'impédance est l'unique réseau d'adaptation d'impédance du dispositif.

Selon un mode de réalisation, le dispositif comprend en outre un filtre passe bas connecté à la borne de mesure.

Selon un mode de réalisation, le composant à valeur réglable est une capacité.

Selon un mode de réalisation, le réseau d'adaptation d'impédance comprend :
un premier composant capacitif connecté entre la borne d'entrée du réseau et un noeud configuré pour recevoir un potentiel de référence ;
un premier composant inductif et un deuxième composant capacitif connectés en série entre ladite borne d'entrée et la borne de sortie du réseau ;
un deuxième composant inductif connecté entre ladite borne de sortie et ledit noeud ; et
le composant à valeur réglable connecté entre ladite borne de sortie et ledit noeud.

Selon un mode de réalisation, des valeurs des composants à valeur fixe sont déterminées de manière que l'impédance réduite du dispositif suite à un décalage d'impédance provoqué par un élément conducteur disposé à proximité du dispositif appartienne, dans un abaque de Smith, à une aire déterminée par toutes les valeurs du composant à valeur réglable.

Un autre mode de réalisation prévoit un système électronique comprenant le dispositif décrit.

Selon un mode de réalisation, le système comprend en outre une source d'un signal radiofréquence connectée au premier port du coupleur du dispositif, et un convertisseur analogique numérique connecté à la borne de mesure du dispositif.

Selon un mode de réalisation, le système comprend un microcontrôleur comportant le convertisseur analogique numérique, un convertisseur numérique analogique commandant le composant à valeur réglable et un processeur configuré pour recevoir des mesures du convertisseur analgique numérique et pour fournir un signal de commande au convertisseur numérique analogique.

Un autre mode de réalisation prévoit un procédé d'utilisation du dispositif ou du système décrit, comprenant les étapes successives suivantes :
a) sélectionner une valeur initiale du composant à valeur réglable et mesurer une tension de la borne de mesure ; et
b) changer la valeur du composant à valeur réglable dans un sens de balayage déterminé puis mesurer la tension de la borne de mesure, l'étape b) étant répétée jusqu'à ce que la dernière mesure de tension soit strictement supérieure à l'avant dernière mesure de tension.

Selon un mode de réalisation, l'étape b) est suivie d'une étape c) de détermination d'un ensemble comprenant chaque valeur du composant à valeur réglable correspondant à une mesure minimale de tension, et de commande du composant à valeur réglable de manière que sa valeur appartienne audit ensemble.

Selon un mode de réalisation, le composant à valeur réglable est commandé de manière que sa valeur soit une valeur médiane dudit ensemble.

Selon un mode de réalisation, le procédé comprend, préalablement à l'étape a), une étape consistant à déterminer des valeurs des composants à valeur fixe du réseau de manière que l'impédance réduite du dispositif suite à un décalage d'impédance provoqué par un élément conducteur disposé à proximité du dispositif appartienne, dans un abaque de Smith, à une aire déterminée par toutes les valeurs du composant à valeur réglable.

Selon un mode de réalisation, la détermination des valeurs des composants à valeur fixe comprend les étapes successives suivantes :
1) sélectionner des valeurs des composants du réseau pour lesquelles l'impédance du dispositif est adaptée à celle de la source du signal radiofréquence dans un environnement anéchoïque ;
2) calculer une impédance réduite du dispositif pour chaque valeur du composant à valeur réglable ;
3) placer un élément conducteur à proximité du dispositif et calculer une impédance réduite du dispositif ; et
4) répéter les étapes 2) et 3) en modifiant au moins l'une des valeurs sélectionnées à l'étape 1) et/ou celui des composants du réseau qui est à valeur réglable tant que l'impédance réduite calculée à l'étape 3) est en dehors d'un ensemble comprenant toutes les impédances réduites calculées à l'étape 2).

Selon un mode de réalisation, les étapes a), b), c) sont mises en œuvre de manière périodique et/ou sur requête d'un utilisateur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, sous la forme d'un circuit, un exemple d'un dispositif d'adaptation d'impédance ;
la figure 2 représente, dans un abaque de Smith, des décalages d'impédance que le dispositif de la figure 1 est en mesure de corriger ;
la figure 3 représente, sous la forme d'un circuit, un mode de réalisation d'un dispositif d'adaptation d'impédance ;
la figure 4 illustre, sous la forme d'un organigramme, un mode de mise en oeuvre d'un procédé d'utilisation du dispositif de la figure 3 ;
la figure 5 illustre un exemple de mise en œuvre du procédé de la figure 4 ;
la figure 6 illustre un autre exemple de mise en œuvre du procédé de la figure 4 ; et
la figure 7 illustre encore un autre exemple de mise en œuvre du procédé de la figure 4.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les différents circuits, par exemple intégrés, pouvant servir de source d'un signal radiofréquence pour un dispositif d'adaptation d'impédance connecté à une antenne n'ont pas été décrits, les modes de réalisation et variantes décrits étant compatibles avec les sources usuelles d'un signal radiofréquence.

Dans la suite de la description, un signal est dit radiofréquence par exemple lorsque la fréquence fondamentale de ce signal est comprise entre 3KHz et 300 GHz, de préférence entre 100 MHz et 30 GHz. Dans la suite de la description, on s'intéresse plus particulièrement à un signal dit sub-gigahertz ou sub-GHz, c'est-à-dire un signal radiofréquence dont la fréquence fondamentale est, par exemple, comprise entre 400 MHz et 950 MHz, bien que les modes de réalisation et variantes qui vont être décrits s'appliquent de manière plus générale aux signaux radiofréquences.

Dans la suite de la description, une première valeur est dite inférieure, respectivement supérieure, à une deuxième valeur si la première valeur est inférieure ou égale, respectivement supérieure ou égale, à la deuxième valeur. En outre, une première valeur est dite strictement inférieure, respectivement strictement supérieure, à une deuxième valeur si la première valeur est inférieure à et différente de, respectivement supérieure à et différente de, la deuxième valeur.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

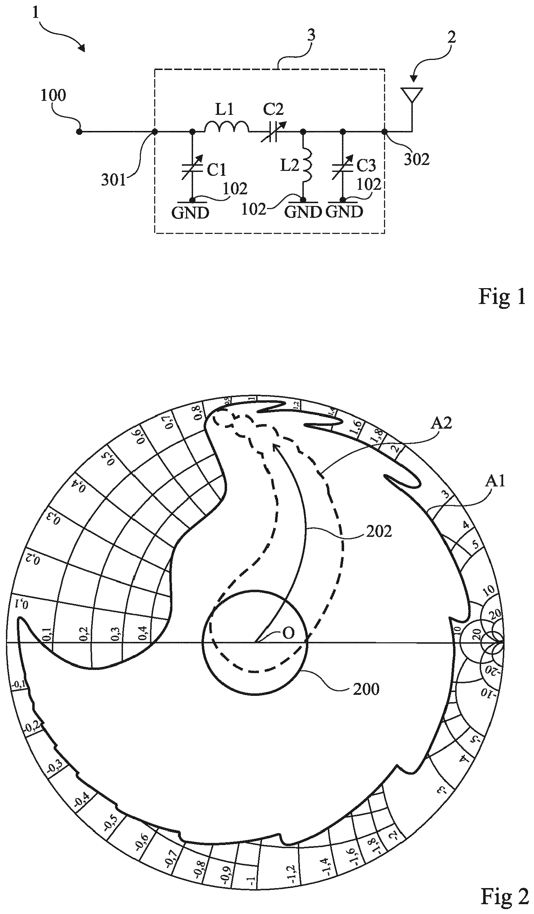

La figure 1 représente, sous la forme d'un circuit, un exemple d'un dispositif 1 d'adaptation d'impédance.

Le dispositif 1 comprend une antenne 2 et une borne d'entrée 100, entre lesquelles est connecté un réseau d'adaptation d'impédance 3. La borne 100 est configurée pour être connectée à une source (non représentée) d'un signal sub-GHz destiné à être émis par l'antenne 2. La source du signal sub-GHz est par exemple un circuit intégré dont une borne de sortie est configurée pour fournir un signal sub-GHz à émettre, cette borne de sortie étant alors connectée à la borne 100.

Le réseau 3 comprend des composants capacitifs et/ou des composants inductifs. Dit autrement, le réseau 3 comprend au moins un composant inductif et/ou au moins un composant capacitif. Les composants inductifs et/ou capacitifs du réseau 3 sont reliés entre eux et à un noeud 102 d'application d'un potentiel de référence, typiquement la masse GND. Les composants inductifs et/ou capacitifs du réseau 3 relient une borne d'entrée 301 du réseau 3 à une borne de sortie 302 du réseau 3. Les bornes 301 et 302 sont connectées respectivement à la borne 100 et à l'antenne 2. Au moins deux composants inductifs et/ou capacitifs du réseau 3 sont à valeur réglable, c'est-à-dire à valeur commandée.

Dans l'exemple de la figure 1, le réseau 3 comprend plus particulièrement une capacité C1 à valeur réglable connectée entre la borne 301 et le noeud 102, une inductance L1 à valeur fixe et une capacité C2 à valeur réglable connectées en série entre les bornes 301 et 302, l'inductance L1 étant connectée à la borne 301, et une inductance L2 à valeur fixe et une capacité C3 à valeur réglable connectées en parallèle entre la borne 302 et le noeud 102.

Lorsque la borne 100 du dispositif 1 est connectée à une source radiofréquence (non représentée) d'un signal sub-GHz, les valeurs des composants C1, C2 et C3 du réseau 3 sont modifiées lors d'une phase d'adaptation d'impédance de manière que l'impédance vue par le signal sub-GHz sur la borne 100 soit égale ou sensiblement égale à l'impédance conjuguée de la source du signal sub-GHz. Plus exactement, les valeurs des composants C1, C2 et C3 sont modifiées de manière que la puissance du signal sub-GHz qui est réfléchi par le dispositif 1 en direction de la borne 100 soit la plus faible possible pour le réseau 3 considéré. Dit autrement, les valeurs des composants C1, C2 et C3 sont modifiées de manière que l'impédance du dispositif 1 soit adaptée à celle de la source du signal sub-GHz.

Pour cela, le dispositif 1 est associé à un détecteur (non représenté) configuré pour fournir une mesure représentative de la puissance du signal réfléchi vers la borne 100, c'est-à-dire représentative de la puissance d'une partie du signal sub-GHz fourni à la borne 100 en direction de l'antenne 2 qui est réfléchie vers la borne 100. Ce détecteur doit être suffisamment sensible pour mesurer la puissance du signal réfléchi, ou puissance réfléchie, lorsque l'impédance du dispositif 1 est adaptée à celle de la source et que cette puissance réfléchie est minimale.

Un tel détecteur, typiquement un détecteur logarithmique, est complexe et couteux à mettre en œuvre. Il serait donc souhaitable de pouvoir mettre en œuvre une phase d'adaptation d'impédance avec un détecteur plus simple.

On considère ici que l'impédance du dispositif 1 est initialement adaptée à celle de la source du signal sub-GHz et que l'impédance du dispositif 1 est modifiée à cause de l'environnement dans lequel se trouve le dispositif 1. Il en résulte que l'impédance du dispositif 1 présente un décalage avec celle de la source. Pour supprimer ce décalage d'impédance, une phase d'adaptation d'impédance est alors mise en œuvre in-situ, c'est-à-dire dans l'environnement d'utilisation du dispositif 1.

Lors de cette phase d'adaptation, comme le réseau 3 comprend au moins deux composants à valeur réglable, la puissance réfléchie présente plusieurs minimums locaux lorsque l'on fait varier les valeurs de ces composants, chaque minimum local correspondant à une association ou combinaison différente de valeurs des composants à valeur réglable. Il en résulte que la mise en œuvre d'une phase d'adaptation d'impédance nécessite d'essayer un très grand nombre de combinaisons de valeurs des composants à valeur réglable pour trouver le minimum de puissance réfléchie, c'est-à-dire celui des minimums locaux correspondant à la plus faible puissance réfléchie. La durée d'une phase d'adaptation d'impédance mise en œuvre avec un dispositif tel que le dispositif 1 est donc importante.

Une phase d'adaptation d'impédance ayant une durée importante n'est pas souhaitable, notamment quand le dispositif 1 et la source du signal sub-GHz appartiennent à un système électronique alimenté par une batterie. En effet, pendant la phase d'adaptation d'impédance, la source émet le signal sub-GHz à la puissance maximale qu'elle peut délivrer de sorte que la puissance réfléchie reste mesurable par le détecteur, même lorsque que l'impédance du dispositif 1 est adaptée à celle de la source et que cette puissance réfléchie a une valeur minimale.

Il en résulte qu'une phase d'adaptation d'impédance mise en œuvre avec le dispositif 1 consomme beaucoup d'énergie. Il serait donc souhaitable de pouvoir réduire la durée de la phase d'adaptation d'impédance, pour réduire la consommation qu'elle engendre.

La figure 2 représente, au moyen d'un abaque de Smith, les décalages d'impédance que le dispositif 1 est en mesure de corriger.

L'abaque de Smith est bien connu de la personne du métier. Un abaque de Smith permet notamment de représenter l'impédance d'une charge, ici l'impédance du dispositif 1, normalisée par rapport à une impédance de référence, ici l'impédance de la source du signal sub-GHz. L'impédance du dispositif 1 normalisée par celle de la source est également appelée impédance réduite du dispositif 1. Le centre O de l'abaque correspond au cas où ces deux impédances sont égales, par exemple à 50 ohms.

Dans un abaque de Smith, toutes les impédances réduites appartenant à un même cercle centré sur le centre O de l'abaque correspondent à un même coefficient de réflexion d'un signal sur la charge, c'est-à-dire, dans cet exemple, à un même coefficient de réflexion d'un signal radiofréquence sur le dispositif 1, ce signal étant fourni par la source radiofréquence connectée à la borne 100 du dispositif 1. Lorsque ce coefficient est exprimé en dB, il est couramment désigné par le sigle RL de l'anglais "Return Loss" (perte de retour). Les impédances réduites disposées à l'intérieur d'un tel cercle correspondent à des coefficients RL plus faibles que celui des impédances réduites disposées sur le cercle.

En figure 2, on a représenté un cercle 200 correspondant aux impédances réduites du dispositif 1 pour lesquelles le coefficient RL est égal à un seuil RLth, le seuil RLth étant de préférence inférieur à -5 dB, par exemple égal à -13 dB dans cet exemple. Dans la suite de la description, on considère, par exemple, que l'impédance du dispositif 1 est adaptée à celle de la source fournissant le signal sub-GHz à la borne 100 si l'impédance réduite du dispositif 1 est disposée sur ou dans le cercle 200, c'est-à-dire si cette impédance réduite correspond à un coefficient RL inférieur ou égal au seuil RLth.

La figure 2 représente, par une aire A1 délimitée par un trait plein, l'ensemble des impédances réduites du dispositif 1 qui peuvent être corrigées par la mise en œuvre d'une phase d'adaptation d'impédance réalisée in-situ, c'est-à-dire qui peuvent être ramenées dans le cercle 200 en modifiant de manière appropriée les valeurs des composants à valeur réglable du réseau 3 du dispositif 1. Dit autrement, l'aire A1 représente l'ensemble des décalages d'impédances que le dispositif 1 est en mesure de corriger pour retrouver une impédance adaptée à celle de la source. Dit encore autrement, l'aire A1 représente l'ensemble des impédances réduites que le dispositif 1 peut prendre.

Les inventeurs ont constaté que les décalages d'impédances d'un dispositif du type du dispositif 1 provoqués par l'environnement d'utilisation du dispositif 1, c'est-à-dire l'environnement dans lequel est placé le dispositif 1 pour y être utilisé, résultent de la présence d'un élément conducteur à proximité du dispositif, par exemple un élément métallique, par exemple un tuyau.

En outre, lorsque l'impédance du dispositif 1 est adaptée à celle de la source et que le dispositif 1 subit un décalage d'impédance provoqué par un élément conducteur placé à proximité du dispositif, l'impédance réduite du dispositif 1 représentée dans un abaque de Smith se déplace du centre de l'abaque vers le bord de l'abaque. Les inventeurs ont constaté que ce déplacement de l'impédance réduite du dispositif 1 suivait sensiblement une même direction, représentée par une flèche 202 en figure 2, quel que soit l'élément conducteur ayant provoqué le décalage d'impédance et quelle que soit la position de cet élément conducteur par rapport au dispositif 1 dès lors que cet élément conducteur est suffisamment proche pour modifier l'impédance du dispositif 1. Cette direction 202 est déterminée par la configuration du réseau 3, c'est-à-dire les composants qu'il comprend et la façon dont ils sont interconnectés, et par l'antenne 2 qui est connectée au réseau 3. Dit autrement, les décalages d'impédances subis par un dispositif 1 ayant un réseau 3 de configuration donnée et une antenne 2 donnée sont prévisibles du fait qu'ils suivent cette direction 202.

Les inventeurs proposent ici de tirer parti du fait que les décalages d'impédances d'un dispositif du type de celui de la figure 1 comprenant un réseau 3 donné et une antenne 2 donnée sont prévisibles. En particulier, les inventeurs proposent de ne conserver qu'un seul composant à valeur réglable dans le réseau d'adaptation d'impédance du dispositif.

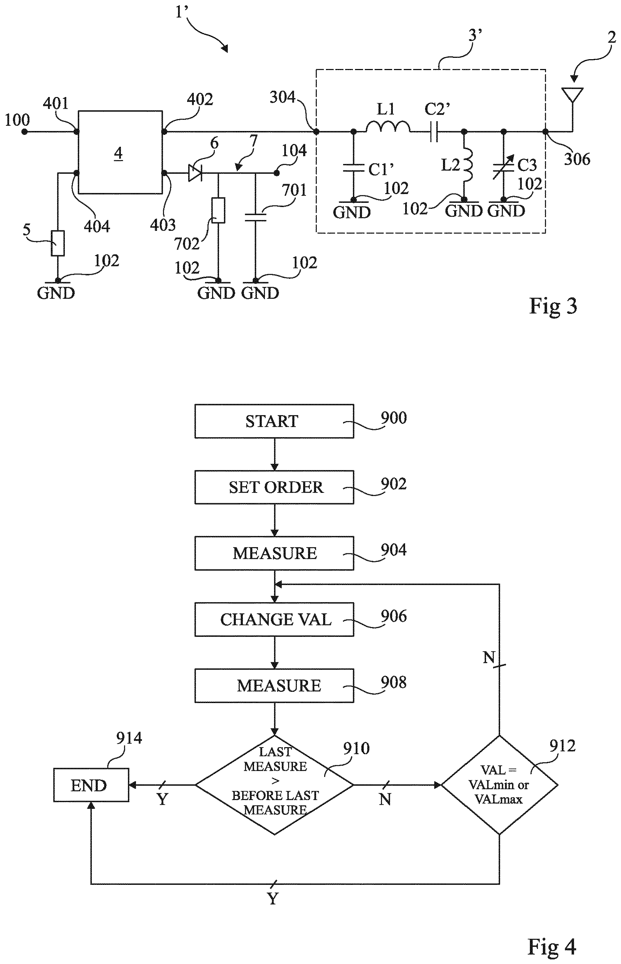

La figure 3 représente, sous la forme d'un circuit, un mode de réalisation d'un dispositif 1' d'adaptation d'impédance.

Le dispositif 1' est similaire au dispositif 1 de la figure 1 en ce qu'il comprend l'antenne 2, la borne 100 et un réseau d'adaptation d'impédance 3' reliant la borne 100 à l'antenne 2. Le réseau 3' du dispositif 1' est l'unique réseau d'adaptation d'impédance du dispositif 1'.

Le réseau 3' comprend, comme le réseau 3 décrit en relation avec la figure 1, des composants inductifs et/ou des composants capacitifs reliés entre eux et au noeud 102. Les composants inductifs et/ou capacitifs du réseau 3' relient une borne d'entrée 304 du réseau 3' à une borne de sortie 306 du réseau 3', les bornes 304 et 306 étant reliées respectivement à la borne 100 et à l'antenne 2, la borne 306 étant de préférence connectée à l'antenne 2.

Le réseau 3' diffère du réseau 3 en ce qu'il ne comprend un unique composant inductif ou capacitif à valeur réglable, tous les autres composants inductifs et/ou capacitifs du réseau 3' étant à valeur fixe.

Selon un mode de réalisation, le composant à valeur réglable est une capacité, les capacités à valeur réglable étant plus simples à mettre en œuvre que les inductances à valeur réglable.

Selon un mode de réalisation, les composants du réseau 3' sont des composants discrets montés sur une carte de circuit imprimé.

Dans l'exemple de la figure 3, le réseau 3' comprend une capacité C1' à valeur fixe connectée entre la borne 304 et le noeud 102, une inductance L1 à valeur fixe et une capacité C2' à valeur fixe connectées entre les bornes 304 et 306, l'inductance L1 étant connectée à la borne 304, et une inductance L2 à valeur fixe et une capacité C3 à valeur réglable connectées en parallèle entre la borne 306 et le noeud 102.

Les valeurs des composants à valeur fixe du réseau 3' sont déterminées de manière que l'impédance réduite du dispositif 1' soumis à un décalage d'impédance provoqué par un élément conducteur à proximité du dispositif 1' appartienne, dans un abaque de Smith, à une aire correspondant à l'ensemble des valeurs possibles du composant à valeur réglable du réseau 3', cette aire comprenant le centre O de l'abaque. Dit autrement, les valeurs des composants à valeur fixe du réseau 3' sont déterminées de manière que l'impédance réduite du dispositif 1' soumis à un décalage d'impédance provoqué par un élément conducteur appartienne à l'ensemble des impédances réduites que peut prendre le dispositif 1' quand la valeur du composant à valeur réglable varie. Dit encore autrement, les valeurs des composants à valeur fixe du réseau 3' sont déterminées de manière qu'un décalage d'impédance du dispositif 1' provoqué par un élément conducteur est corrigeable par une modification de la valeur de son composant à valeur réglable.

A titre d'exemple, pour un réseau 3' donné et pour une antenne 2 donnée, les valeurs des composants à valeur fixe du réseau 3' sont déterminées en mettant en œuvre, par exemple au moyen d'un outil de simulation, les étapes successives suivantes :
1) sélectionner des valeurs des composants du réseau 3' permettant d'adapter l'impédance du dispositif 1' à la source du signal sub-GHz lorsque le dispositif 1' est dans un environnement anéchoïque ;
2) déterminer, pour ces valeurs sélectionnées, l'ensemble des impédances réduites du dispositif 1 correspondant à l'ensemble des valeurs possibles du composant à valeur réglable ;
3) provoquer un ou plusieurs décalages d'impédances avec un élément conducteur et déterminer, pour chacun de ces décalages d'impédance, l'impédance réduite du dispositif 1' ; et
4) vérifier si chaque impédance réduite déterminée à l'étape 3) est incluse dans l'ensemble des impédances réduites du dispositif 1' déterminé à l'étape 2). Dit autrement, l'étape 4) consiste à vérifier si l'impédance réduite calculée à l'étape 3) appartient, dans un abaque de Smith, à une aire représentant l'ensemble des impédances réduites prises par le dispositif 1 lorsque toute la plage de valeurs possibles du composant à valeur réglable est balayée.

Les étapes 2) et 3) sont répétées après avoir modifié au moins l'une des valeurs sélectionnées à l'étape 1) et/ou celui des composants du réseau qui est à valeur réglable tant que chaque impédance réduite calculée à l'étape 3) est en dehors de l'ensemble des impédances réduites calculées à l'étape 2). Quand chaque impédance réduite calculée à l'étape 3) appartient à l'ensemble des impédances réduites calculées à l'étape 2), la détermination des valeurs des composants à valeur fixe du réseau 3' est terminée. Les valeurs déterminées sont les valeurs utilisées lors de la dernière mise en œuvre des étapes 2) et 3).

La personne du métier est en mesure de déterminer les valeurs des composants à valeur fixe du réseau d'une manière différente de celle décrite ci-dessus à titre d'exemple.

En se référant de nouveau à la figure 2, une aire A2 délimitée par un trait en pointillé représente l'ensemble des impédances réduites du dispositif 1' qui correspondent à l'ensemble des valeurs possibles du composant à valeur réglable du réseau 3'. En figure 2, l'aire A2 est représentée dans le cas où les valeurs des composants à valeur fixe du réseau 3' ont été déterminées de la façon indiquée précédemment. Ainsi, lorsque le dispositif 1' subit un décalage d'impédance provoqué par un élément conducteur de son environnement, l'impédance réduite du dispositif 1' se déplace dans la direction 202. Lorsque l'impédance réduite du dispositif 1' reste dans l'aire A2, une modification appropriée de la valeur du composant C3 permet de ramener l'impédance réduite du dispositif 1' dans le cercle 200. Dit autrement, lorsque l'impédance réduite du dispositif 1' ayant subi un décalage d'impédance reste dans l'aire A2, une phase d'adaptation d'impédance permet de ramener l'impédance réduite du dispositif 1' dans le cercle 200, c'est-à-dire permet de réadapter l'impédance du dispositif 1' à celle de la source du signal sub-GHz.

Du fait que le réseau 3' d'adaptation d'impédance du dispositif 1' ne comprend qu'un seul composant à valeur réglable, la durée d'une phase d'adaptation d'impédance mise en œuvre avec le dispositif 1' est plus courte que celle d'une phase d'adaptation d'impédance mise en œuvre avec un dispositif du type du dispositif 1 dont le réseau d'adaptation d'impédance comprend au moins deux composants à valeur réglable.

Par ailleurs, du fait que le réseau 3' ne comprend qu'un seul composant C3 à valeur réglable, lorsque l'on fait varier la valeur du composant C3, la puissance réfléchie présente un unique minimum, et non pas plusieurs minimums locaux comme dans un dispositif du type du dispositif 1.

Les inventeurs proposent ici de tirer parti du fait qu'il y a un unique minimum de puissance réfléchie lorsque la valeur du composant C3 varie pour utiliser un circuit de mesure ou détecteur moins sensible que ceux nécessaires à la mise en œuvre d'une phase d'adaptation d'impédance dans un dispositif du type de celui de la figure 1.

En effet, dans un dispositif du type du dispositif 1, du fait qu'il y a plusieurs minimums locaux de puissance réfléchie, il est nécessaire de connaître les valeurs de ces minimum locaux pour déterminer lequel de ces minimums locaux correspond à la plus faible puissance réfléchie. L'adaptation d'impédance est ensuite mise en œuvre en commandant les composants à valeur réglable du réseau 3 de manière que leurs valeurs soient celles correspondant au minimum local pour lequel la puissance réfléchie est la plus faible. A l'inverse, dans le dispositif 1', du fait qu'il n'y qu'un seul minimum de puissance réfléchie, il n'est pas nécessaire de connaître précisément la valeur correspondante de la puissance réfléchie.

Selon un mode de réalisation, comme illustré en figure 3, le détecteur du dispositif 1' comprend un coupleur directionnel 4. Le coupleur 4 comprend un port 401 configuré pour être connecté à la source d'un signal sub-GHz, le port 401 étant relié, de préférence connecté, à la borne 100. Le coupleur 4 comprend en outre un port 402. Le coupleur 4 est configuré pour transmettre au port 402 un signal sub-GHz reçu par son port 401. Le port 402 est relié, de préférence connecté, à la borne 304 du réseau 3'. Le coupleur 4 comprend en outre un port 403. Le coupleur 4 est configuré pour transmettre le signal sub-GHz reçu par son port 402 au port 403. Le signal sub-GHz reçu par le port 402 correspond au signal sub-GHz réfléchi par l'ensemble du réseau 3' et de l'antenne 2, ce signal réfléchi se propageant en direction de la borne 100. Le signal sur le port 403 correspond en pratique à une version atténuée du signal reçu par le port 402. Cette atténuation résulte de pertes par couplage entre les ports 402 et 403, et est par exemple de l'ordre de 20 dB.

Dans l'exemple de la figure 3, le coupleur 4 comprend en outre un port 404, vers lequel est transmis une version atténuée du signal reçu par le port 401. Cette atténuation résulte de pertes par couplage entre les ports 401 et 404, et est par exemple égale à celle entre les ports 402 et 403. Une résistance 5 est connectée entre le port 404 et le noeud 102 pour adapter l'impédance vue par le port 404 à l'impédance du port 404 du coupleur 4, qui est, en pratique, égale à celle de la source du signal sub-GHz.

Selon un autre exemple non représenté, le coupleur 4 ne comprend pas le port 404, et la résistance 5 fait alors partie du coupleur 4.

Selon un mode de réalisation dans lequel les composants du réseau 3' sont des composants discrets montés sur une carte de circuit imprimé, le coupleur 4 est de préférence un composant discret monté sur cette carte de circuit imprimé.

Le détecteur du dispositif 1' comprend en outre une diode 6 reliant le port 403 à une borne de mesure 104 du dispositif 1'. Une électrode de la diode 6, son anode, est reliée, de préférence connectée au port 403, l'autre électrode de la diode 6, sa cathode, est reliée, de préférence connectée, à la borne 104.

La diode 6 est configurée pour redresser le signal sub-GHz présent sur le port 403 et pour fournir une tension redressée Vmes correspondante à la borne 104.

Selon un mode de réalisation dans lequel les composants du réseau 3' sont des composants discrets montés sur une carte de circuit imprimé, la diode 6 est, de préférence, un composant discret monté sur cette carte de circuit imprimé.

Le détecteur du dispositif 1' comprend en outre un filtre passe bas 7 connecté à la borne 104. Le filtre 7 est configuré pour lisser la tension redressée Vmes présente sur la borne 104, de manière que la tension Vmes 104 soit une tension continue ou DC. Dans cet exemple, le filtre passe-bas 7 comprend une capacité 701 connectée entre la borne 104 et le noeud 102, et une résistance 702 connectée entre la borne 104 et le noeud 102, en parallèle de la capacité 701. La valeur de la résistance 702 est choisie pour que l'impédance vue par le port 403 soit égale à l'impédance du port 403 du coupleur 4.

Selon un mode de réalisation dans lequel les composants du réseau 3' sont des composants discrets montés sur une carte de circuit imprimé, le filtre 7 est de préférence constitué d'un ou plusieurs composants discrets montés sur cette carte de circuit imprimé.

La tension Vmes est représentative de la puissance réfléchie. En particulier, plus la valeur de la tension Vmes sur la borne est élevée, respectivement faible, plus la puissance réfléchie est élevée, respectivement faible, la tension Vmes étant minimale lorsque la puissance réfléchie est minimale, c'est-à-dire quand l'impédance du dispositif 1' est adaptée à celle de la source radiofréquence connectée à la borne 100.

La borne de mesure 104 est configurée pour être connectée à un convertisseur analogique numérique ("Analog to Digital Converter") ou ADC (non représenté en figure 4). L'ADC, lorsqu'il est connecté à la borne 104, fait partie du détecteur du dispositif 1'. L'ADC est configuré pour fournir un signal ou code numérique sur plusieurs bits, ce code numérique étant représentatif de la valeur de la tension Vmes, donc de celle de la puissance réfléchie.

L'ADC comprend une plage de conversion délimitée par une tension maximale Vmax et une tension minimale Vmin. Si la tension Vmes sur la borne 104 a une valeur supérieure ou égale à la tension Vmax, l'ADC indiquera que la tension Vmes mesurée est égale à la tension Vmax. Si la tension Vmes sur la borne 104 a une valeur inférieure ou égale à la tension Vmin, l'ADC indiquera que la tension Vmes mesurée est égale à la tension Vmin. La tension Vmin détermine la sensibilité maximale du détecteur, c'est-à-dire la puissance minimale du signal fourni par le port 403 au détecteur qui conduit à une tension Vmes sur la borne 104 dans la plage de conversion de l'ADC.

Lors d'une phase d'adaptation d'impédance réalisée in-situ, la tension Vmes est supérieure à la tension Vmin tant que le coefficient RL est supérieur à un seuil RLlim (en dB) déterminé par la relation RLlim = Ds + C - Pi, avec Ds la sensibilité maximale du détecteur en dBm, Pi la puissance du signal fourni à la borne 100 en dBm et C les pertes par couplage entre les ports 402 et 403 en dB.

A titre d'exemple, le seuil RLlim est égal à -13 dB lorsque la puissance Pi est égale à 10 dBm, les pertes par couplage C sont égales à 20 dB et la sensibilité maximum Ds est égale à -23 dBm.

Selon un mode de réalisation, l'ADC du détecteur du dispositif 1' appartient à un microcontrôleur (non représenté) configuré pour mettre en œuvre une phase d'adaptation d'impédance au moyen dispositif 1'. De préférence, le microcontrôleur comprend un convertisseur numérique analogique ("Digital to Analog Converter") ou DAC, configuré pour commander le composant C3 à valeur réglable du réseau 3'. De préférence, le microcontrôleur comprend également un microprocesseur recevant des données de l'ADC et fournissant des données au DAC pour commander la valeur du composant C3.

La figure 4 illustre, sous la forme d'un organigramme, un mode de mise en œuvre d'un procédé d'utilisation du dispositif 1'. Ce procédé d'utilisation correspond, en pratique, à un procédé d'adaptation, et plus particulièrement un procédé pour adapter in-situ l'impédance du dispositif 1' à celle de la source radiofréquence connectée à la borne 101 du dispositif 1'.

Dans ce procédé, on fait varier la valeur du composant C3 et on mesure la tension Vmes pour chaque valeur prise par le composant C3 tant que la tension Vmes mesurée est décroissante ou constante, et l'on arrête de faire varier la valeur du composant C3 dès que la tension Vmes mesurée est strictement croissante. Cela permet de mesurer la tension Vmes sur une partie seulement de la plage des valeurs possibles du composant C3, ce qui permet de réduire le temps nécessaire à la mise en œuvre du procédé. On tire ici profit du fait que la puissance réfléchie ne présente qu'un seul minimum lorsque la valeur du composant C3 varie.

A une étape 900 (bloc "START"), on sélectionne une valeur initiale Cinit du composant C3. A titre d'exemple, la valeur Cinit est la valeur courante du composant C3 au début du procédé, sa valeur maximale Cmax ou sa valeur minimale Cmin, de préférence sa valeur courante. A l'étape 900 les valeurs des composants à valeur fixe du réseau 3' ont été préalablement fixées de la manière décrite précédemment, et l'ensemble du dispositif 1' et de la source radiofréquence connectée à la borne 100 (figure 3) est dans son environnement d'utilisation. En pratique, le dispositif 1' fait alors partie d'un système électronique comprenant l'ADC connecté à la borne 104 et un circuit de commande du composant à valeur réglable du réseau 3'.

A une étape 902 suivante (bloc "SET ORDER"), on détermine, parmi le sens croissant et le sens décroissant, un sens de balayage, ou de parcours, des valeurs du composant C3 à partir de la valeur Cinit. Plus particulièrement, l'ordre croissant ou décroissant des valeurs successives du composant C3 est déterminé de manière que, lors des étapes suivantes du procédé, au moins les deux premières valeurs mesurées de la tension Vmes soient décroissantes, ou, dit autrement, ne soient pas strictement croissantes.

La mise en œuvre de cette étape est à la portée de la personne du métier, par exemple en sélectionnant un sens de balayage, en mesurant, pour ce sens de balayage, la tension Vmes pour au moins les deux premières valeurs successives du composant C3, en vérifiant si le sens de balayage sélectionné correspond à une tension Vmes mesurée décroissante, et en modifiant le sens de balayage si nécessaire.

A une étape 904 suivante (bloc "MEASURE"), la tension Vmes sur la borne 104 est mesurée pour la valeur Cinit du composant C3. On notera que, si l'étape précédente 902 comprend une mesure de la tension Vmes sur la borne 104 pour la valeur Cinit, cette étape 904 peut être omise.

A une étape 906 suivante (bloc "CHANGE VAL"), la valeur du composant C3 est modifiée en respectant le sens de balayage fixé à l'étape 902.

A une étape 908 suivante (bloc "MEASURE"), la tension Vmes sur la borne 104 est mesurée pour la valeur courante du composant C3.

A une étape 910 suivante (bloc "LAST MEASURE>BEFORE LAST MEASURE"), on vérifie si la dernière tension Vmes mesurée est strictement supérieure à l'avant dernière tension Vmes mesurée. On appelle ici "tension Vmes mesurée" la mesure ou valeur de la tension Vmes qui est fournie par l'ADC connecté à la borne 104. Une tension Vmes mesurée peut correspondre à une valeur différente de celle de la tension Vmes effectivement présente sur la borne 104, typiquement lorsque la tension Vmes sur la borne 104 est en dehors de la plage de conversion de l'ADC.

Si la dernière tension Vmes mesurée n'est pas strictement supérieure à l'avant dernière tension Vmes mesurée (branche N du bloc 910), le procédé se poursuit à une étape 912 (bloc "VAL=VALmin or VALmax"). Si la dernière tension Vmes mesurée est strictement supérieure à l'avant dernière tension Vmes mesurée (branche Y du bloc 910), le procédé se poursuit à une étape 914 (bloc "END").

A l'étape 912, on vérifie si la valeur courante du composant C3 est égale à sa valeur maximale Cmax ou à sa valeur minimale Cmin. Plus particulièrement, si les valeurs du composant C3 sont balayées dans l'ordre croissant, on vérifie si la valeur courante du composant C3 est égale à sa valeur maximale Cmax, et, si les valeurs du composant C3 sont balayées dans l'ordre décroissant, on vérifie si la valeur courante du composant C3 est égale à sa valeur minimale Cmin.

Si c'est le cas (branche Y du bloc 912), le procédé se poursuit à l'étape 914. Si ce n'est pas le cas (branche N du bloc 912), le procédé se poursuit à l'étape 906.

L'étape 914 consiste à sélectionner une valeur du composant C3 permettant d'adapter l'impédance du dispositif 1' à celle de la source du signal sub-GHz. Le composant C3 est alors commandé pour qu'il prenne la valeur sélectionnée. Pour cela, on détermine parmi toutes les valeurs prises par le composant C3 lors des étapes précédentes, un ensemble de valeurs du composants C3 correspondant à la tension Vmes mesurée minimale, puis on sélectionne une valeur du composant C3 dans cet ensemble.

La mise en œuvre du procédé décrit en relation avec la figure 4 permet d'adapter l'impédance du dispositif 1' à celle de la source du signal sub-GHz.

En effet, dans le cas où l'ensemble déterminé à l'étape 914 comprend plusieurs valeurs du composant C3, ces valeurs correspondent toutes à des tensions Vmes mesurées égales à la tension Vmin. Dit autrement, ces valeurs correspondent toutes à une tension Vmes sur la borne 104 inférieure à la tension Vmin de l'ADC. Ces valeurs du composant C3 correspondent donc toutes à un coefficient RL inférieur au seuil RLlim.

En outre, dans le cas où l'ensemble déterminé à l'étape 914 ne comprend qu'une valeur, cela signifie que la tension Vmes correspondant à cette valeur du composant C3 est minimale, et correspond donc à une puissance réfléchie minimale pour le dispositif 1' considéré. Ce cas se présente quand la tension Vmes a une valeur minimale supérieure à la tension Vmin de l'ADC, c'est-à-dire que le coefficient RL reste supérieur seuil RLlim quelle que soit la valeur du composant C3. Même dans ce cas, le procédé décrit ci-dessus permet de minimiser au mieux la puissance réfléchie pour le dispositif 1', et donc d'adapter l'impédance du dispositif 1' à celle de la source du signal sub-GHz. Ce cas correspond par exemple à un décalage d'impédance pour lequel l'impédance réduite du dispositif 1' n'appartient pas l'aire A2 (figure 2) .

Selon un mode de réalisation, le composant C3 à valeur réglable est commandé de manière que sa valeur soit égale à une valeur médiane de l'ensemble déterminé à l'étape 914. Par valeur médiane, on entend ici une valeur de l'ensemble pour laquelle l'ensemble comprend autant de valeurs inférieures à la valeur médiane que de valeurs supérieures à une valeur près.

Selon un mode de réalisation, le procédé est mis en œuvre à la suite d'une requête d'un utilisateur du dispositif 1' et/ou de manière périodique.

Selon un mode de réalisation, le procédé décrit ci-dessus est mis en œuvre par un microcontrôleur comprenant l'ADC qui est connecté à la borne 104 du dispositif 1' et un circuit de commande du composant C3, par exemple un DAC. Le microcontrôleur comprend un microprocesseur ou unité de traitement associé à une mémoire comprenant des instructions qui, lorsqu'elles sont lues par le microprocesseur du microcontrôleur, entrainent la mise en œuvre du procédé.

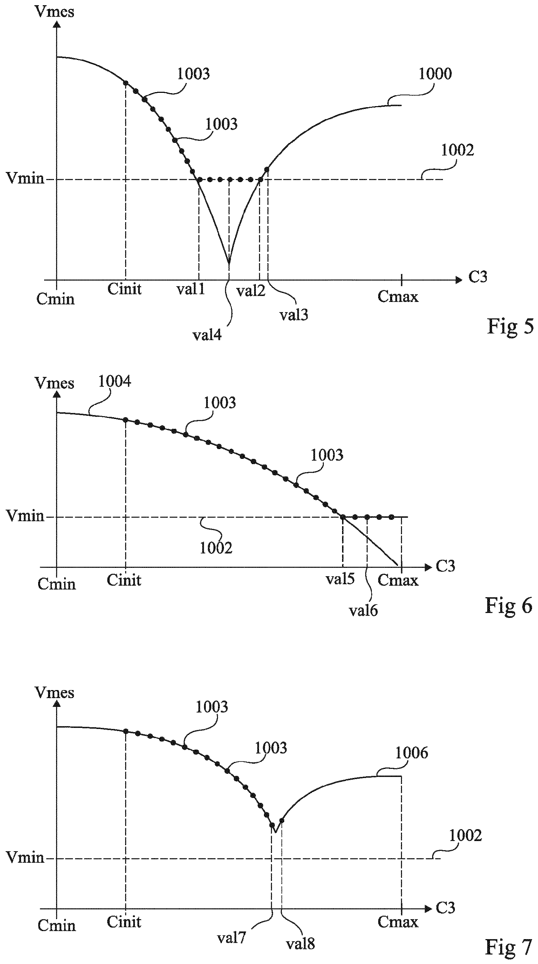

Des exemples de mises en œuvre du procédé de la figure 4 vont maintenant être décrits en relation avec les figures 5, 6 et 7.

La figure 5 illustre un exemple de mise en œuvre du procédé décrit en relation avec la figure 4. L'exemple de la figure 5 correspond au cas où, sur toute la plage de valeurs possibles du composant C3, la tension Vmes sur la borne 104 décroît jusqu'à une valeur minimale puis croît à partir de cette valeur minimale, et où la valeur minimale de la tension Vmes sur la borne 104 est inférieure à la tension minimale Vmin de l'ADC.

Une courbe 1000 représente l'évolution de la tension Vmes sur la borne 104 en fonction de la valeur du composant C3 du réseau 3'. Un axe horizontal 1002 représente la tension Vmin de l'ADC connecté à la borne de mesure 104 du dispositif 1'. Des points 1003 représentent les tensions Vmes mesurées par le détecteur du dispositif 1', c'est-à-dire les mesures de la tension Vmes fournies par l'ADC. En figure 5, pour ne pas surcharger la figure, un nombre réduit de points sont représentés et seulement deux de ces points 1003 sont référencés. Chaque point 1003 est obtenu pour une valeur correspondante du composant C3 prise pendant la mise en œuvre du procédé.

La valeur Cinit du composant C3 est, dans cet exemple, la valeur courante du composant C3 au début du procédé (étape 900, figure 4), et les valeurs du composant C3 sont balayées dans le sens croissant (étape 902, figure 4).

Plusieurs mesures de la tension Vmes (étapes 904, figure 4) sont ensuite effectuées en modifiant, entre chaque deux mesures successives, la valeur du composant C3 (étapes 906, figure 4).

Jusqu'à une valeur val2 du composant C3, chaque tension Vmes mesurée est inférieure à la tension Vmes mesurée précédemment (étape 910, branche N, figure 4).

Plus particulièrement, dans cet exemple, chaque mesure de la tension Vmes est strictement inférieure à la mesure précédente de la tension Vmes pour les valeurs successives croissantes du composant C3 allant de la valeur Cinit à une valeur val1, et est égale à la mesure précédente de la tension Vmes pour les valeurs successives croissantes du composant C3 allant de la valeur val1 à la valeur val2.

En revanche, lorsque le composant passe à une valeur val3 suivant la valeur val2 (étape 906, figure 4), la tension Vmes mesurée pour la valeur val3 (étape 908, figure 4) est strictement supérieure à la tension Vmes mesurée pour la valeur val2 (étape 910, branche Y, figure 4). Il en résulte que l'on arrête de modifier la valeur du composant C3 et de mesurer la tension Vmes pour chaque valeur du composant C3, sans avoir balayé toutes les valeurs du composant C3. Cela permet de réduire la durée de mise en œuvre du procédé par rapport à celle d'un procédé dans lequel on aurait balayé toutes les valeurs du composant C3.

On détermine ensuite (étape 914, figure 4), parmi toutes les valeurs successives prises par le composant C3, l'ensemble de valeurs correspondant à une tension Vmes mesurée minimale. Dans cet exemple, cet ensemble comprend toutes les valeurs du composant C3 allant de la valeur val1 à la valeur val2, qui correspondent toutes à une tension Vmes sur la borne 104 inférieure à la tension Vmin, donc à des coefficients RL inférieurs au seuil RLlim. Une valeur val4 du composant C3 est alors sélectionnée dans cet ensemble, et le composant C3 est commandé pour que sa valeur soit égale à la valeur sélectionnée.

De préférence, la valeur val4 est la valeur médiane de l'ensemble. Cela permet, dans le cas de la figure 5, d'être plus proche de la puissance réfléchie minimale que si la valeur val4 avait été sélectionnée aléatoirement dans l'ensemble.

La figure 6 illustre un autre exemple de mise en œuvre du procédé décrit en relation avec la figure 4. L'exemple de la figure 6 correspond au cas où, sur toute la plage de valeurs possibles du composant C3, la tension Vmes est uniquement décroissante lorsque les valeurs du composant C3 sont balayées dans l'ordre croissant, et où la tension Vmes sur la borne 104 prend des valeurs inférieures à la tension minimale Vmin de l'ADC.

Une courbe 1004 représente l'évolution de la tension Vmes sur la borne 104 en fonction de la valeur du composant C3 du réseau 3'. Comme en figure 5, l'axe 1002 représente la tension Vmin et des points 1003 représentent les tensions Vmes mesurées par le détecteur du dispositif 1', le nombre de points représentés et le nombre de points référencés étant réduits pour ne pas surcharger la figure. Chaque point 1003 est obtenu pour une valeur correspondante du composant C3 prise pendant la mise en œuvre du procédé.

Dans cet exemple, la valeur Cinit du composant C3 est la valeur courante du composant C3 au début du procédé (étape 900, figure 4), et les valeurs du composant C3 sont balayées dans l'ordre croissant (étape 902, figure 4).

Plusieurs mesures de la tension Vmes (étapes 904, figure 4) sont effectuées en modifiant, entre chaque deux mesures successives, la valeur du composant C3 (étapes 906, figure 4).

Jusqu'à la valeur Cmax, chaque tension Vmes mesurée est inférieure ou égale à la tension Vmes mesurée précédemment (étape 910, branche N, figure 4).

Plus particulièrement, dans cet exemple, chaque mesure de la tension Vmes est strictement inférieure à la mesure précédente de la tension Vmes pour les valeurs du composant C3 allant de la valeur Cinit à une valeur val5, et est égale à la mesure précédente de la tension Vmes pour les valeurs du composant C3 allant de la valeur val5 à la valeur Cmax.

L'ensemble de valeurs correspondant à une tension Vmes mesurée minimale (étape 914, figure 4) est alors déterminé. Dans cet exemple, cet ensemble comprend toutes les valeurs du composant C3 allant de la valeur val5 à la valeur Cmax, qui correspondent toutes à une tension Vmes sur la borne 104 inférieure à la tension Vmin, donc à des coefficients RL inférieurs au seuil RLlim.

Une valeur val6 du composant C3 est alors sélectionnée dans cet ensemble de valeurs du composant C3, et le composant C3 est commandé pour que sa valeur soit égale à la valeur sélectionnée.

La figure 7 illustre encore un autre exemple de mise en œuvre du procédé décrit en relation avec la figure 4. L'exemple de la figure 7 correspond au cas où, sur toute la plage de valeurs possibles du composant C3, la tension Vmes sur la borne 104 décroit jusqu'à une valeur minimale puis croit à partir de cette valeur minimale, et où la tension Vmes minimale sur la borne 104 est supérieure à la tension Vmin de l'ADC.

Une courbe 1006 représente l'évolution de la tension Vmes sur la borne 104 en fonction de la valeur du composant C3 du réseau 3'. L'axe horizontal 1002 représente la tension Vmin. Des points 1003 représentent les tensions Vmes mesurées par le détecteur du dispositif 1', le nombre de points représentés et le nombre de points référencés étant réduits pour ne pas surcharger la figure. Chaque point 1003 est obtenue pour une valeur correspondante du composant C3 prise pendant la mise en œuvre du procédé.

Dans cet exemple, la valeur Cinit du composant C3 est la valeur courante du composant C3 au début du procédé (étape 900, figure 4), et les valeurs du composant C3 sont balayées dans le sens croissant (étape 902, figure 4).

Plusieurs mesures de la tension Vmes (étapes 904, figure 4) sont effectuées en modifiant, entre chaque deux mesures successives, la valeur du composant C3 (étapes 906, figure 4).

Jusqu'à une valeur val7, chaque tension Vmes mesurée est strictement inférieure à la tension Vmes mesurée précédente (étape 910, branche N, figure 4). En revanche, lorsque le composant passe à une valeur val8 suivant la valeur val7 (étape 906, figure 4), la mesure de la tension Vmes correspondant à la valeur val8 (étape 908, figure 4) est strictement supérieure à la mesure précédente de la tension Vmes correspondant à la valeur val7 (étape 910, branche Y, figure 4). Il en résulte que l'on arrête de modifier la valeur du composant C3 et de mesurer la tension Vmes pour chaque valeur du composant C3 (étape 914, figure 4), sans avoir balayé toutes les valeurs du composant C3. Cela permet de réduire la durée de mise en œuvre du procédé par rapport à celle d'un procédé dans lequel on aurait balayé toutes les valeurs du composant C3.

L'ensemble de valeurs correspondant à une mesure minimale de la tension Vmes (étape 914, figure 4) ne comprend ici que la valeur val7. Le composant C3 est alors commandé pour que sa valeur soit égale à cette unique valeur val7 de l'ensemble.

On a décrit ci-dessus des exemples de modes de réalisation et variantes pour lesquels le seuil RLlim est égal à -13 dB. La personne du métier est en mesure de modifier la valeur du seuil RLmin. Par exemple, la valeur du seuil RLlim peut être diminuée en prévoyant d'augmenter la puissance Pi pour respecter RLlim = Ds + C - Pi, les pertes par couplage C et la sensibilité Ds du détecteur étant des caractéristiques intrinsèques du dispositif 1' qui dépendent du coupleur 4 et de l'ADC utilisés.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, la mise en œuvre du réseau 3' ne se limite pas à l'exemple représenté en figure 3, et la personne du métier est en mesure de prévoir d'autres exemples de réseaux 3' comprenant plusieurs composants inductifs et/ou capacitifs dont un seul composant à valeur réglable, et saura mettre en œuvre le procédé décrit en relation avec la figure 4 pour ces autres réseaux 3'.

Enfin, la mise en oeuvre pratique des modes de réalisation et variantes décrits est à la portée de la personne du métier à partir des indications fonctionnelles données ci-dessus. En particulier, la personne du métier saura faire varier la valeur du composant à valeur réglable, par exemple avec un pas constant. A titre d'exemple, lorsque le composant est commandé par une tension de sortie d'un convertisseur numérique analogique, ce pas constant est par exemple déterminé par la variation de la tension de sortie du convertisseur entre deux codes binaires successifs fournis en entrée du convertisseur.

## Revendications

1. Dispositif comprenant :
une antenne (2) ;
un coupleur directionnel (4) comprenant un premier port (401) configuré pour être connecté à une source d'un signal radiofréquence, un deuxième port (402) vers lequel est transmis un signal reçu par le premier port (401) et un troisième port (403) vers lequel est transmis un signal reçu par le deuxième port (402) ;
un réseau d'adaptation d'impédance (3') comprenant des composants inductifs et/ou capacitifs (C1', L1, C2', L2) à valeur fixe et un unique composant inductif ou capacitif (C3) à valeur réglable, une borne d'entrée (304) du réseau étant reliée au deuxième port (402) du coupleur (4) et une borne de sortie (306) du réseau (4) étant reliée à l'antenne (2) ; et
une diode (6) reliant le troisième port (403) du coupleur (4) à une borne de mesure (104) du dispositif (1') configurée pour être connectée à un convertisseur analogique numérique.

2. Dispositif selon la revendication 1, dans lequel le réseau d'adaptation d'impédance (3') est l'unique réseau d'adaptation d'impédance du dispositif (1').

3. Dispositif selon la revendication 1 ou 2, comprenant en outre un filtre passe bas (7) connecté à la borne de mesure (104) .

4. Dispositif selon l'une quelconque des revendications 1 à 3, dans lequel le composant (C3) à valeur réglable est une capacité.

5. Dispositif selon la revendication 4, dans lequel le réseau d'adaptation d'impédance (3') comprend :
un premier composant capacitif (C1') connecté entre la borne d'entrée (304) du réseau (3') et un noeud (102) configuré pour recevoir un potentiel de référence (GND) ;
un premier composant inductif (L1) et un deuxième composant capacitif (C2') connectés en série entre ladite borne d'entrée (304) et la borne de sortie (306) du réseau (3') ;
un deuxième composant inductif (L2) connecté entre ladite borne de sortie (306) et ledit noeud (102) ; et
le composant (C3) à valeur réglable connecté entre ladite borne de sortie (306) et ledit noeud (102).

6. Dispositif selon l'une quelconque des revendications 1 à 5, dans lequel des valeurs des composants (C1', C2', L1, L2) à valeur fixe sont déterminées de manière que l'impédance réduite du dispositif (1') suite à un décalage d'impédance provoqué par un élément conducteur disposé à proximité du dispositif (1') appartienne, dans un abaque de Smith, à une aire (A2) déterminée par toutes les valeurs du composant (C3) à valeur réglable.

7. Système électronique comprenant le dispositif selon l'une quelconque des revendications 1 à 6.

8. Système électronique selon la revendication 7, comprenant en outre une source d'un signal radiofréquence connectée au premier port (401) du coupleur (4) du dispositif (1'), et un convertisseur analogique numérique connecté à la borne de mesure (104) du dispositif (1').

9. Système électronique selon la revendication 7 ou 8, comprenant un microcontrôleur comportant le convertisseur analogique numérique, un convertisseur numérique analogique commandant le composant (C3) à valeur réglable et un processeur configuré pour recevoir des mesures du convertisseur analgique numérique et pour fournir un signal de commande au convertisseur numérique analogique.

10. Procédé d'utilisation d'un dispositif (1') selon l'une quelconque des revendications 1 à 6 ou d'un système selon l'une quelconque des revendications 7 à 9, comprenant les étapes successives suivantes :
a) sélectionner une valeur initiale (Cinit) du composant à valeur réglable (C3) et mesurer une tension (Vmes) de la borne de mesure (104) ; et
b) changer la valeur du composant à valeur réglable (C3) dans un sens de balayage déterminé puis mesurer la tension (Vmes) de la borne de mesure (104), l'étape b) étant répétée jusqu'à ce que la dernière mesure de tension (Vmes) soit strictement supérieure à l'avant dernière mesure de tension (Vmes).

11. Procédé selon la revendication 10, dans lequel l'étape b) est suivie d'une étape c) de détermination d'un ensemble comprenant chaque valeur du composant à valeur réglable (C3) correspondant à une mesure minimale de tension (Vmin), et de commande du composant à valeur réglable (C3) de manière que sa valeur appartienne audit ensemble.

12. Procédé selon la revendication 11, dans lequel le composant à valeur réglable (C3) est commandé de manière que sa valeur soit une valeur médiane dudit ensemble.

13. Procédé selon l'une quelconque des revendications 10 à 12, comprenant, préalablement à l'étape a), une étape consistant à déterminer des valeurs des composants (C1', C2', L1, L2) à valeur fixe du réseau (3') de manière que l'impédance réduite du dispositif (1') suite à un décalage d'impédance provoqué par un élément conducteur disposé à proximité du dispositif (1') appartienne, dans un abaque de Smith, à une aire (A2) déterminée par toutes les valeurs du composant (C3) à valeur réglable.

14. Procédé selon la revendication 13, dans lequel la détermination des valeurs des composants (C1', C2', L1, L2) à valeur fixe comprend les étapes successives suivantes :
1) sélectionner des valeurs des composants (C1', C2', C3, L1, L2) du réseau pour lesquelles l'impédance du dispositif (1') est adaptée à celle de la source du signal radiofréquence dans un environnement anéchoïque ;
2) calculer une impédance réduite du dispositif (1') pour chaque valeur du composant (C3) à valeur réglable ;
3) placer un élément conducteur à proximité du dispositif (1') et calculer une impédance réduite du dispositif (1') ; et
4) répéter les étapes 2) et 3) en modifiant au moins l'une des valeurs sélectionnées à l'étape 1) et/ou celui des composants du réseau qui est à valeur réglable tant que l'impédance réduite calculée à l'étape 3) est en dehors d'un ensemble comprenant toutes les impédances réduites calculées à l'étape 2).

15. Procédé selon l'une quelconque des revendications 10 à 14, dans lequel les étapes a), b), c) sont mises en œuvre de manière périodique et/ou sur requête d'un utilisateur.
